(19) Europäisches Patentamt
European Patent Office
Office européen des brevets

(11) **EP 0 854 574 B1**

(12) **EUROPÄISCHE PATENTSCHRIFT**

(45) Veröffentlichungstag und Bekanntmachung des Hinweises auf die Patenterteilung:
**31.10.2007 Patentblatt 2007/44**

(51) Int Cl.:
**H03K 17/16** (2006.01)

(21) Anmeldenummer: **98100648.9**

(22) Anmeldetag: **15.01.1998**

(54) **Treiberschaltung**

Driver circuit

Circuit d'attaque

(84) Benannte Vertragsstaaten:
**FR GB IT**

(30) Priorität: **16.01.1997 DE 19701377**

(43) Veröffentlichungstag der Anmeldung:
**22.07.1998 Patentblatt 1998/30**

(73) Patentinhaber: **SGS-THOMSON MICROELECTRONICS GMBH**
**85630 Grasbrunn (DE)**

(72) Erfinder: **Erckert, Ricardo**
**83043 Bad Aibling (DE)**

(74) Vertreter: **Hirsch, Peter**
**Klunker Schmitt-Nilson Hirsch**
**Winzererstrasse 106**
**80797 München (DE)**

(56) Entgegenhaltungen:
**EP-A- 0 535 797      EP-A- 0 620 644**
**EP-A- 0 627 818      GB-A- 2 257 854**
**US-A- 5 194 760      US-A- 5 311 069**

EP 0 854 574 B1

**Beschreibung**

Die Erfindung betrifft eine Treiberschaltung für ein flankensteilheitsgeregeltes impulsweises Schalten einer Last.

Aus der Druckschrift GB-A-2,257,854 ist eine Treiberschaltung bekannt, bei der zur schnellen Entladung einer Rückkoppelkapazität, d.h. zur Verbesserung des Abschaltverhaltens, eine schaltbare Stromspiegelschaltung an den Eingang eines Regelverstärkers angeschlossen ist.

Zur Reduzierung von elektromagnetischen Störabstrahlungen werden die Anstiegsgeschwindigkeit und die Abfallgeschwindigkeit der Ein- und Ausschaltvorgänge von Schaltereinrichtungen üblicherweise mittels einer Rückkopplungsschleife geregelt. Mit Anstiegsgeschwindigkeiten und Abfallgeschwindigkeiten von etwa 1V/$\mu$s geht man heute ohne ernsthafte Probleme um. Für Anwendungen für impulsweisen Betrieb, wie bei Schrittmotortreibern usw., eignen sich Anstiegs- und Abfallgeschwindigkeiten von etwa 10V/$\mu$s bis 30 V/$\mu$s besser. Bei derartigen Anstiegs- und Abfallgeschwindigkeiten wird allerdings die Stabilität der Regelschleife kritischer. Ursache hierfür sind Nichtlinearitäten der Regelschleife zusammen mit einer Laufzeitverzögerung der Treiberstufen, welche beträchtlich zum gesamten Phasennachlauf der Regelschleife beitragen.

Für Schalteranwendungen, bei welchen eine enge Definition der Anstiegs- und Abfallgeschwindigkeit nicht erforderlich ist, nutzt man die Drain-Gate-Kapazität eines MOS-Transistors aus. Dabei ist die Gateansteuerung auf einige Mikroampere strombegrenzt. Derart einfache Schaltungen hängen stark von der Herstellungsstreuung der Gate-Kapazität des MOS-Transistors ab. Zudem sind die Einschaltverzögerung und die Ausschaltverzögerung recht lang, da die Gate-Spannung beim Einschalten und Ausschalten aufgrund der relativ kleinen Gate-Kapazität des MOS-Transistors nur langsam ansteigt bzw. abfällt, und das selbst in Spannungsbereichen, die weit von dem Einschaltschwellenwert des MOS-Transistors abliegen.

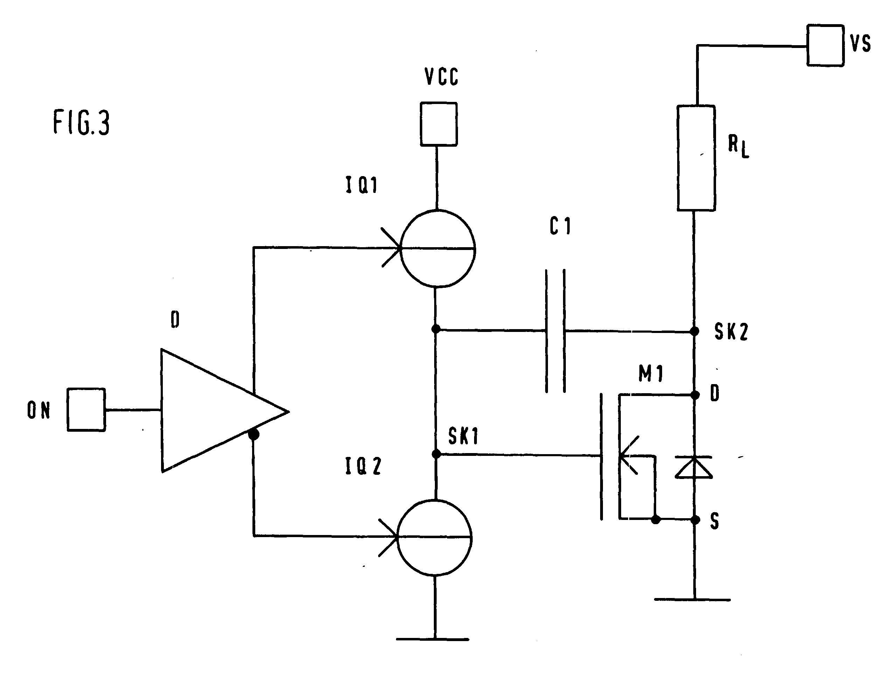

Eine bekannte Treiberschaltung ist in Fig. 3 gezeigt. In dem Sammelband: B. Murari, F. Bertotti und G.A. Vignola [Hgs.]: "Smart Power ICs", Berlin: Springer-Verlag ist auf Seite 189 eine ähnliche Anordnung dargestellt. Dabei bezeichnen ON, VCC und VS einen Eingangsanschlußstift, einen ersten Spannungsversorgungsstift bzw. einen zweiten Spannungsversorgungsstift einer integrierten Schaltung.

Ein ON zugeführtes impulsförmiges Schaltsteuersignal gelangt auf einen Treiber D und von dessen beiden Ausgängen auf je eine von zwei Stromquellen IQ1 und IQ2, die im eingeschalteten Zustand einen Strom I1 bzw. I2 liefern und bei denen es sich üblicherweise um eine Gegentaktstufe handelt, deren beide Stufen von dem Treiber D gegenläufig angesteuert werden. An einen ersten Schaltungsknoten SK1 zwischen IQ1 und IQ2 ist das Gate eines Schalttransistors M1 in Form eines N-Kanal-MOS-Transistors angeschlossen. Mittels des Schalttransistors M1 wird eine Last $R_L$ geschaltet, die in Reihe zum Schalttransistor M1 angeordnet ist. Zwischen SK1 und einem zweiten Schaltungsknoten SK2 zwischen dem Schalttransistor M1 und der Last $R_L$ befindet sich eine Kapazität C1, mittels welcher die Miller-Kapazität der Draine-Gate-Kapazität von M1 dargestellt ist.

Die Geschwindigkeit, mittels welcher die Ausgangsspannung am Schaltungsknoten SK2 geschaltet werden kann, ist begrenzt durch den Gate-Ladestrom bzw. Gate-Entladestrom.

Die Abfallgeschwindigkeit einer Abfallflanke der Ausgangsspannung am Drain-Anschluß D von M1 ist

$$dV/dt \ = \ - \ I1/C1. \qquad\qquad 1$$

Die Anstiegsgeschwindigkeit einer Anstiegsflanke der Ausgangsspannung am Drain-Anschluß von D von M1 ist

$$dV/dt \ = \ I2/C1. \qquad\qquad 2$$

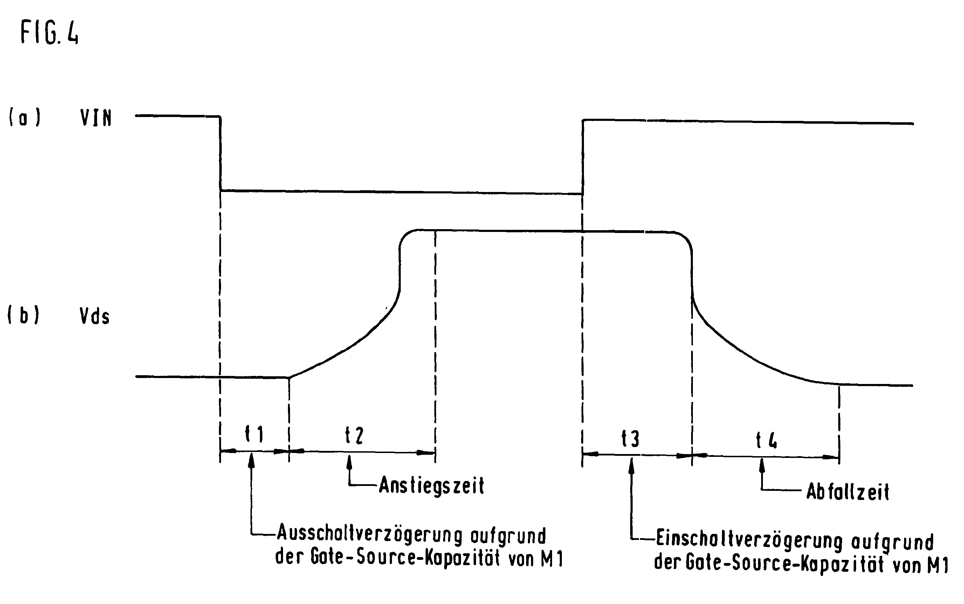

Gewöhnlich macht man I1 und I2 gleich groß, um für beide Flanken eines Spannungsimpulses die gleichen Anstiegs- bzw. Abfallgeschwindigkeiten zu erhalten. Leider hängt die Drain-Gate-Kapazität eines MOS-Transistors stark von dessen Gate-Drain-Spannung ab. Eine typische Impulsantwort einer Treiberschaltung gemäß Fig. 3 ist in Fig. 4 dargestellt. Dabei zeigt Fig. 4 (a) einen dem Eingangsanschlußstift ON zugeführten Schaltsteuerimpuls VIN, während Fig. 4 (b) die Impulsantwort der in Fig. 3 gezeigten Treiberschaltung zeigt, und zwar in Form der Drain-Source-Spannung von M1.

Die Impulsantwort in Fig. 4 (b) zeigt einerseits eine Einschaltverzögerung t1 und eine Ausschaltverzögerung t3, welche von der Gate-Source-Kapazität von M1 herrühren. t2 und t4 zeigen eine Anstiegsflanke bzw. Abfallflanke der Impulsantwort. Während der Zeitspannen t2 und t4 ist die Flankengeschwindigkeit nicht konstant und unterliegt Herstellungstoleranzen.

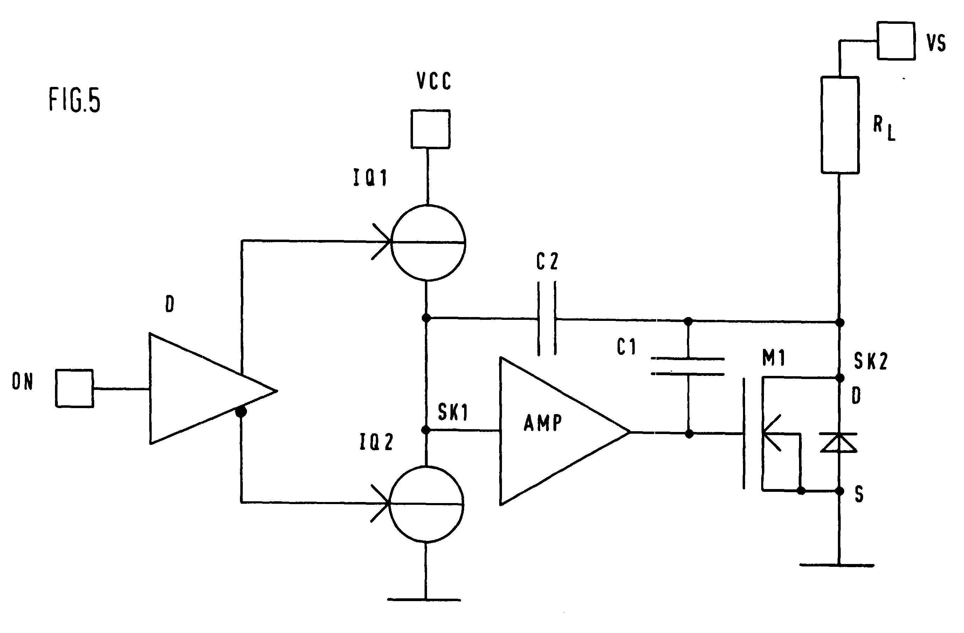

Zum Erhalt präziser definierter Flanken und zur Reduzierung der Verzögerungen (t1 und t3 in Fig. 4 (b)) wird bisweilen eine Regelschleife verwendet. Eine herkömmliche Ausführungsform mit einer solchen Regelschleife ist in Fig. 5 gezeigt. Diese Schaltung ist der in Fig. 3 gezeigten Schaltung recht ähnlich. Zusätzlich zu einem Schaltungsteil gemäß Fig. 3 weist die in Fig. 5 gezeigte Ausführungsform einen Verstärker AMP und einen Rückkopplungskondensator C2 auf. Bei dieser Ausführungsform wird die Flankengeschwindigkeit durch die Ströme I1 (abfallende Flanke) und I2 (Anstiegsflanke) und den Kondensator C2 definiert. Der Ausgang des Verstärkers AMP ist genügend niederohmig, um das Gate von M1 zu laden und zu entladen, wobei die höchstmögliche Gate-Drain-Kapazität C1 angenommen wird, die man im Betriebsbereich von M1 findet. Der Verstärker liefert so viel Ausgangsstrom, daß C1 wesentlich schneller als C2 umgeladen werden kann. Dadurch fallen die Verzögerungszeiten t1 und t3 in Fig. 4 (b) praktisch weg. Hinzu kommt, daß der Rückkopplungskondensator C2 gut definiert werden kann, da er weniger von Produktionsstreuungen abhängt als C1.

Betrachtet man einen Einschaltvorgang, wird die nicht dargestellte Gate-Source-Kapazität von M1 mit dem maximalen Strom aufgeladen, den der Verstärker AMP liefern kann. Die Einschaltverzögerung (t3 in Fig. 4 (b)) kann daher um Größenordnungen verringert werden. Nähert sich die Gate-Source-Spannung der Einschaltschwellenspannung von M1, nimmt die Drain-Spannung ab, was zur Entladung von C2 führt. Nachdem M1 eingeschaltet ist, nimmt der Einschaltwiderstand von M1 viel rascher ab als bei der in Fig. 3 gezeigten Schaltung.

Die Schaltung der Fig. 5 enthält eine vollständige Regelschleife. Diese muß so ausgelegt sein, daß sie bei der maximalen Verstärkung von AMP und für die maximale Steilheit des Leistungs-MOS-Transistors M1, der zusammen mit der Last $R_L$ als eine zweite Verstärkerstufe wirkt, stabil bleibt. Die Steilheit von M1 hängt stark von dessen Arbeitspunkt ab. Die Regelschleifenverstärkung nimmt (für induktive Lasten) mit dem Laststrom zu. Damit die Regelschleife stabil bleibt, muß sie genügend Phasenspielraum haben, um auch beim maximalen Arbeitsstrom von M1 ihre Stabilität zu behalten. Gleichzeitig muß die Schleifenverstärkung genügend hoch sein, um für niedrige Lastströme eine geeignete Flankenregelung zu ermöglichen. Nimmt man beispielsweise für M1 einen Arbeitsstrombereich von 100 mA bis 1A an, ändert sich die Schleifenverstärkung um eine ganze Größenordnung.

Mit derzeit verfügbaren Methoden kann Stabilität für Flankengeschwindigkeiten bis etwa 1 V/μs erreicht werden. Der dominante Pol wird gewöhnlich durch die Gate-Kapazität von M1 zusammen mit der Ausgangsimpedanz des Treiberverstärkers AMP definiert. Für diesen Stabilisierungsansatz muß die Phasenverschiebung durch den Verstärker AMP bei der höchsten Frequenz, bei welcher die Schleifenverstärkung 1 übersteigt, weniger als π/4 sein (für ein Überschwingen von 5 %).

Um höhere Flankengeschwindigkeiten (z.B. 30 V/μs) zu erreichen, muß die Ausgangsimpedanz des Verstärkers AMP deutlich verringert werden. Hierdurch verschiebt sich der dominante Pol der Regelschleife zu höheren Frequenzen hin. Dadurch steigt der Einfluß der die Stabilität bedrohenden Laufzeiten des Verstärkers AMP (Pole zweiter Ordnung) so weit an, daß die Stabilität nicht mehr über den gesamten nichtlinearen Arbeitsbereich, insbesondere für hohe Gatespannungen von M1, gewährleistet ist.

Mit der vorliegenden Erfindung soll eine Treiberschaltung mit verbesserter Stabilität der Flankenregelung erreicht werden. Dies wird erreicht mit einer erfindungsgemäßen Treiberschaltung, wie sie im Anspruch 1 definiert ist. Weiterbildung der erfindungsgemäßen Treiberschaltung sind in den abhängigen Ansprüchen angegeben.

Das Kernmerkmal der Erfindung besteht darin, daß die Flankenregelungsschleife vorübergehend linearisiert wird, und zwar jeweils während der Dauer einer Anstiegs- oder Abfallflanke.

Zu diesem Zweck weist die erfindungsgemäße Treiberschaltung die schaltbare Stromspiegelschaltung auf, die während Zeitspannen, die von der Timer-Schaltung vorgegeben werden und im wesentlichen mit den Zeitdauern der Anstiegs- oder Abfallflanken übereinstimmen, in Stromspiegelbetrieb geschaltet wird und deren Stromspiegelbetrieb außerhalb der Flankenseiten abgeschaltet wird. Während des Stromspiegelbetriebes wird der Ausgang des Verstärkers AMP von dem Stromspiegel so stark belastet, daß es zu einer Linearisierung der Regelschleife kommt.

Die Erfindung wird nun anhand einer Ausführungsform näher erläutert. In den beiliegenden Zeichnungen zeigen:

Fig. 1    eine Ausführungsform einer erfindungsgemäßen Treiberschaltung;

Fig. 2    in schematisierter Weise eine Schaltkennlinie der in Fig. 1 gezeigten Treiberschaltung;

Fig. 3    eine bereits erläuterte herkömmliche Treiberschaltung;

Fig. 4(a)   einen Schaltsteuerimpuls;

Fig. 4(b)   eine Impulsantwort der herkömmlichen Schaltung nach Fig. 3; und

Fig. 5    die ebenfalls bereits erläuterte zweite Ausführungsform einer herkömmlichen Treiberschaltung.

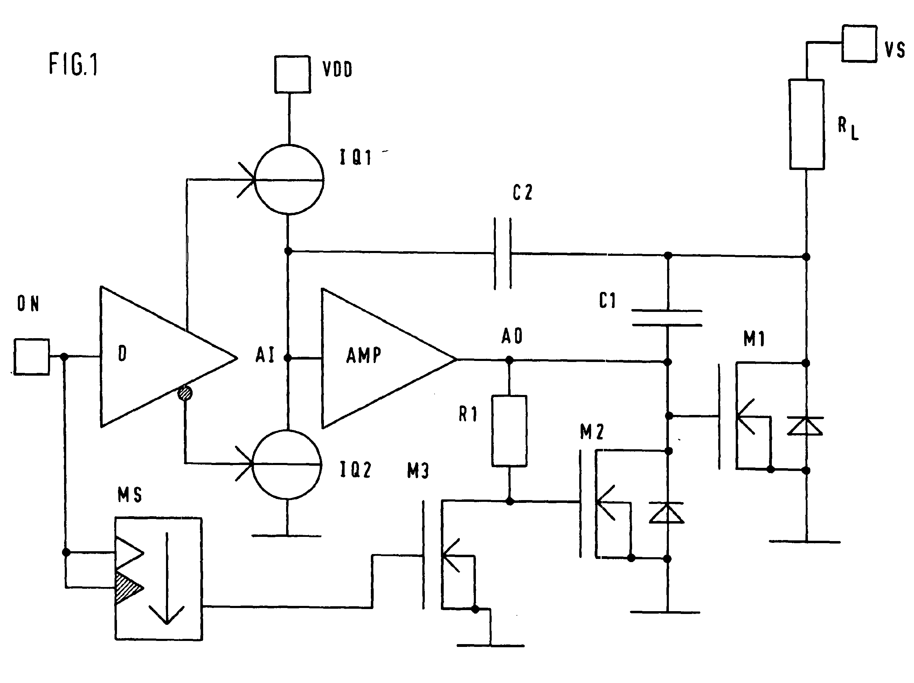

Die in Fig. 1 gezeigte Ausführungsform einer erfindungsgemäßen Treiberschaltung enthält einen Schaltungsteil, der mit der herkömmlichen Schaltung gemäß Fig. 5 übereinstimmt, und weist zusätzlich eine als Timer-Schaltung wirkende monostabile Kippschaltung MS, einen über einen Widerstand R1 als Diode geschalteten Diodentransistor M2, der zusammen mit dem Schalttransistor M1 einen Stromspiegel bildet, und eine zwischen eine monostabile Kippschaltung MS und den Diodentransistor M2 geschalteten Schalttransistor M3 auf. Die genaue Verschaltung ist in Fig. 1 dargestellt.

Die monostabile Kippschaltung MS wird sowohl durch Anstiegsflanken als auch durch Abfallflanken des dem Eingangsanschlußstift ON zugeführten impulsförmigen Schaltsteuersignals zur Abgabe eines Ausgangsimpulses definierter Dauer getriggert. Dadurch wird während einer Dauer, die im wesentlichen der Flankendauer entspricht, M3 nichtleitend geschaltet, wodurch M2 leitend geschaltet wird, so daß R1 und M2 als MOS-Diode wirken. In diesem Einschaltzustand von M2 wirken M1 und M2 als Stromspiegel, der einen Laststrom erzeugt, der unabhängig von der Schleifenverstärkung der Flankenregelungsschaltung ist. Die Schleifenregelung selbst wird wie im Fall der Fig. 5 mittels des Rückkopplungskondensators C2, des Verstärkers AMP und der Stromquellen IQ1 und IQ2 durchgeführt.

Außerhalb der Zeiten, in welcher sich die monostabile Kippschaltung MS im getriggerten Zustand befindet, leitet M3, so daß der Diodentransistor M2 sperrt und die Stromspiegelbelastung für den Ausgang des Verstärkers AMP wegfällt. Dadurch, daß M2 sperrt, erhält M1 eine höhere Gate-Source-Spannung, so daß er in einen stärker leitenden Zustand gelangt, in dem er einen kleineren Durchlaßwiderstand $R_{DS\ ON}$ aufweist.

Mit Hilfe der in Fig. 1 gezeigten erfindungsgemäßen Treiberschaltung kann die Frequenzkennlinie der Flankenregelschleife für eine genau definierte Verstärkung (die durch das Kanalbreitenverhältnis von M2 und M1 festgelegt werden kann) optimiert werden. Dies ermöglicht eine Optimierung der Flankenregelschleife für Anwendungen mit höherer Schaltgeschwindigkeit, welche Flankengeschwindigkeiten bis zu 20 V/μs oder auch mehr erfordern.

Durch die Maßnahmen der erfindungsgemäßen Schaltung werden also gleichzeitig eine Stabilisierung der Regelschleife während der Schaltimpulsflanken und ein niedriger Durchlaßwiderstand des Schalttransistors zwischen den Schaltimpulsflanken erreicht.

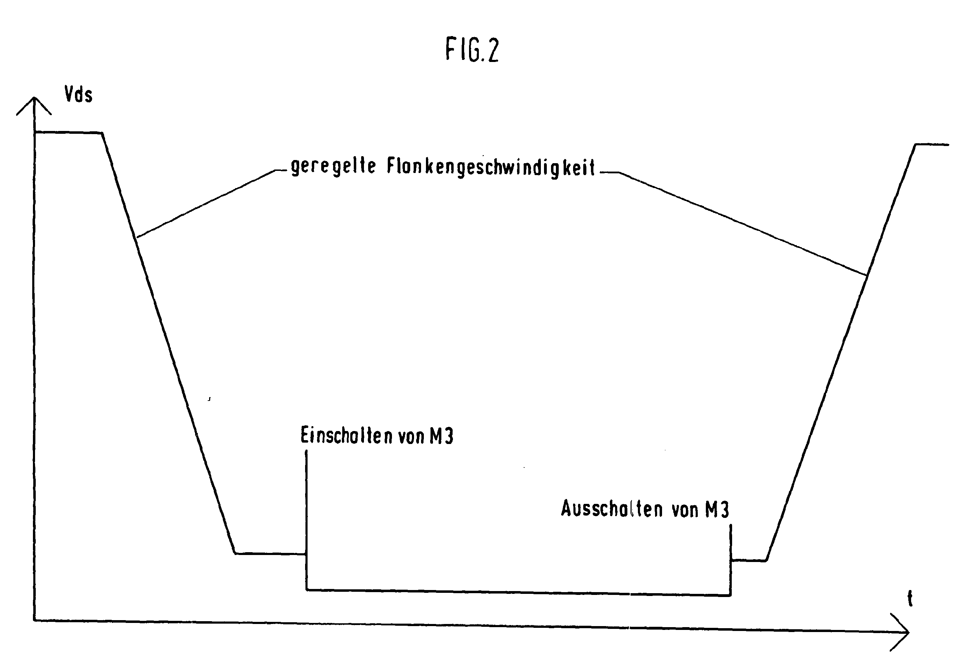

Fig. 2 zeigt einen Spannungsverlauf über der Drain-Source-Strecke des Schalttransistors M1, wobei die Drain-Source-Spannung Vds in Abhängigkeit von der Zeit dargestellt ist.

Während der Impulsflanken, genauer gesagt, während der Zeiten, während welcher die monostabile Kippschaltung MS getriggert ist, ist M3 ausgeschaltet, so daß die Abfallflanke und die Anstiegsflanke des jeweiligen Schaltimpulses eine stabil geregelte Flankengeschwindigkeit aufweisen. Wie Fig. 2 zeigt, ist Vds während der Einschaltzeit von M3 zwischen den Impulsflanken niedriger als bei gesperrten M3. Somit ist der Durchlaßwiderstand von M1 während der Einschaltdauer von M3 niedriger, als wenn M3 gesperrt ist.

**Patentansprüche**

1. Treiberschaltung für ein flankensteilheitsgeregeltes impulsweises Schalten einer Last ($R_L$) mit:

   a) einem die Last ($R_L$) schaltenden MOS-Schalttransistor (M1);
   b) einem Regelkreis mit einem Verstärker (AMP), der einen mit einer Schaltsteuerimpulsquelle (ON) gekoppelten Verstärkereingang (AI), einen mit dem Gate des MOS-Schalttransistors (M1) verbundenen Verstärkerausgang (AO) und eine Rückkopplungskapazität (C2) aufweist;
   c) einer schaltbaren Stromspiegelschaltung mit einem durch den MOS-Schalttransistor (M1) gebildeten Stromspiegeltransistor und einem als Stromspiegeldiode geschalteten Diodentransistor (M2), wobei ein Verbindungspunkt zwischen dem Diodentransistor (M2) und dem Gate des MOS-Schalttransistors (M1) mit dem Verstärkerausgang (AO) verbunden ist;
   d) und einer Timer-Schaltung (MS), der eingangsseitig die Schaltsteuerimpulse von der Schaltsteuerimpulsquelle (ON) zuführbar sind und mittels welcher der Diodentransistor (M2) während im wesentlichen der Zeitdauer einer jeden Schaltsteuerimpulsflanke in einen leitenden Zustand und ansonsten in einen nicht-leitenden Zustand steuerbar ist.

2. Treiberschaltung nach Anspruch 1, bei welcher zwischen den Verstärkerausgang (AO) und eine Steuerelektrode des Diodentransistors (M2) ein Widerstand geschaltet ist.

3. Treiberschaltung nach Anspruch 1 oder 2, bei welcher die Timer-Schaltung eine sowohl durch ansteigende als auch durch abfallende Flanken der Schaltsteuerimpulse triggerbare monostabile Kippschaltung aufweist, deren Ausgangssignal während des Verweilens im vorübergehend stabilen Zustand ein leitend Schalten und während des Verweilens im dauerstabilen Zustand ein nicht-leitend Schalten des Diodentransistors (M2) bewirkt.

4. Treiberschaltung nach einem der Ansprüche 1 bis 3, bei welcher zwischen den Ausgang der Timer-Schaltung (MS) und die Steuerelektrode des Diodentransistors (M2) ein Ansteuertransistor (M3) geschaltet ist.

5. Treiberschaltung nach einem der Ansprüche 1 bis 4, bei welcher der Diodentransistor (M2) und/oder der Ansteuertransistor (M3) als MOS-Transistor ausgebildet ist.

6. Treiberschaltung nach einem der Ansprüche 1 bis 5, bei welcher der Verstärkereingang (AI) mit dem Ausgang einer Gegentaktschaltung (I1, I2) verbunden ist, die von einer mit der Schaltsteuerimpulsquelle (ON) gekoppelten Treiberstufe (D) ansteuerbar ist.

7. Treiberschaltung nach einem der Ansprüche 1 bis 6, bei welcher sich der MOS-Schalttransistor (M1) in Reihenschaltung mit der zu schaltenden Last ($R_L$) befindet,
die Last ($R_L$) zwischen einen hochpotentialseitigen Spannungsversorgungsanschluß (Vs) und den MOS-Schalttransistor (M1) geschaltet ist
und der MOS-Schalttransistor (M1) als N-Kanal-MOS-Tranistor ausgebildet ist.

8. Treiberschaltung nach Anspruch 7, bei welcher der Diodentransistor (M2) und der Ansteuertransistor (M3) als N-Kanal-MOS-Transistor ausgebildet sind.

## Claims

1. A driver circuit for edge slope-controlled pulsed switching of a load ($R_L$) comprising:

    a) a MOS switching transistor (M1) switching the load ($R_L$);
    b) a control loop with an amplifier (AMP) having an amplifier input (AI) couplet with a switch control pulse source (ON), an amplifier output (AO) connected with the gate of the MOS switching transistor (M1), and a feedback capacitance (C2);
    c) a switchable current mirror circuiz with a current mirror transistor formed by the MOS switching transistor (M1), and a diode transistor (M2) wired as a current mirror diode, a connection point between the diode transistor (M2) and the gate of the MOS switching transistor (M1) being connected with the amplifier output (AO); and
    d) a timer circuit (MS) which is supplied on an input side the switch control pulses from the switch control pulse source (ON), and by means of which the diode transistor (M2) is switched into a conductive sate for essentially the duration of each switch control pulse edge and otherwise into a nonconductive state.

2. The driver circuit of claim 1, wherein a resistor is switched between the amplifier output (AO) and a control electrode of the diode transistor (M2).

3. The driver circuit of claim 1 or 2, wherein the timer circuit has a monostable circuit adapted to be triggered both by rising and by trailing edges of the switch control pulses, its output signal rendering the diode transistor (M2) conductive during the stay in the temporarily stable state and rendering it nonconductive during the stay in the permanently stable state.

4. The driver circuit of any of claims 1 to 3, wherein a drive transistor (M3) is connected between the output of the timer circuit (M3) is connected between the output of the timer circuit (MS) and the control electrode of the diode transistor (M2).

5. The driver circuit of any of claims 1 to 4, wherein the diode transistro (M2) and/or the drive transistor (M3) are formed as MOS transistors.

6. The driver circuit of any of claims 1 to 5, wherein the amplifier inut (AI) is connected with the output of a push-pull circuit (I1, I2) adapted to be driven by a driver stage (D) coupled with the switch control pulse source (ON).

7. The driver circuit of any of claims 1 to 6, wherein the MOS switching transistor (M1) is in series connection with the load to be switched ($R_L$),
the load ($R_L$) is switched between a voltage supply connection (VS) on the high potential side and the MOS switching transistor (M1), and
the MOS switching transistor (M1) is formed as an N-channel MOS transistor.

8. The driver circuit of claim 7, wherein the diode transistor (M2) and the drive transistor (M3) are formed as N-channel MOS transistors.

**Revendications**

1. Circuit d'attaque pour la commutation d'une charge ($R_L$) par impulsions commandée par la pente des fronts, comportant :

   a) un transistor de commutation MOS (M1) commutant la charge ($R_L$) ;
   b) une boucle de régulation avec un amplificateur (AMP) qui comprend une entrée d'amplificateur (AI) couplée à une source d'impulsions de commande de commutation (ON), une sortie d'amplificateur (AO) reliée à la grille du transistor de commutation MOS (M1) et une capacité de rétroaction (C2) ;
   c) un circuit à miroir de courant pouvant être commuté, comportant un transistor à miroir de courant formé par le transistor de commutation MOS (M1) et un transistor à diodes (M2) branché en tant que diode à miroir de courant, un point de liaison entre le transistor à diodes (M2) et la grille du transistor de commutation MOS (M1) étant connecté à la sortie de l'amplificateur (AO) ;
   d) et un circuit de temporisation (MS) auquel peuvent être délivrées par la source d'impulsions de commande de commutation (ON), les impulsions de commande côté entrée et au moyen duquel le transistor à diodes (M2) peut être commandé pour être à l'état passant sensiblement pendant la durée de chaque front d'impulsion de commande et sinon, pour être à l'état non passant.

2. Circuit d'attaque selon la revendication 1, dans lequel une résistance est branchée entre la sortie de l'amplificateur (AO) et une électrode de commande du transistor à diodes (M2).

3. Circuit d'attaque selon l'une quelconque des revendications 1 ou 2, dans lequel le circuit de temporisation comprend une bascule monostable, pouvant être déclenchée aussi bien par les fronts montants que par les fronts descendants des impulsions de commande de commutation, dont le signal de sortie entraîne pendant la durée de l'état stable temporairement, un état passant du transistor à diodes (M2) et pendant la durée de l'état stable en durée, un état non passant.

4. Circuit d'attaque selon l'une quelconque des revendications 1 à 3, dans lequel un transistor d'attaque (M3) est branché entre la sortie du circuit de temporisation (MS) et l'électrode de commande du transistor à diodes (M2).

5. Circuit d'attaque selon l'une quelconque des revendications 1 à 4, dans lequel le transistor à diodes (M2) et/ou le transistor d'attaque (M3) est (sont) conçu(s) sous la forme d'un transistor MOS.

6. Circuit d'attaque selon l'une quelconque des revendications 1 à 5, dans lequel l'entrée de l'amplificateur (AI) est reliée à la sortie d'un circuit symétrique (I1, I2) qui peut être commandé par un étage d'attaque (D) relié à une source d'impulsions de commande de commutation (ON).

7. Circuit d'attaque selon l'une quelconque des revendications 1 à 6, dans lequel le transistor de commutation MOS (M1) se trouve monté en série avec la charge ($R_L$) devant être commutée,
   la charge ($R_L$) est branchée entre une alimentation en tension (Vs) côté potentiel plus et le transistor de commutation MOS (M1)
   et le transistor de commutation MOS (M1) est conçu sous la forme d'un transistor MOS à canal N.

8. Circuit d'attaque selon la revendication 7, dans lequel le transistor à diodes (M2) et le transistor d'attaque (M3) sont conçus sous la forme d'un transistor MOS à canal N.

FIG.1

VS

$R_L$

M1

C1

C2

M2

A0

R1

M3

VDD

IQ1

AMP

AI

IQ2

D

ON

MS

FIG.2

Vds

geregelte Flankengeschwindigkeit

Einschalten von M3

Ausschalten von M3

t

EP 0 854 574 B1

FIG.3

FIG. 4

(a) VIN

(b) Vds

t1  t2  Anstiegszeit

Ausschaltverzögerung aufgrund der Gate-Source-Kapazität von M1

t3  t4  Abfallzeit

Einschaltverzögerung aufgrund der Gate-Source-Kapazität von M1

FIG.5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2257854 A

**In der Beschreibung aufgeführte Nicht-Patentliteratur**

- Smart Power ICs. Springer-Verlag, 189